# EUROPEAN PATENT APPLICATION

(11) **EP 4 746 267 A1**
(43) Date of publication of application: **20.05.2026**
(21) Application number: 24847536.0
(22) Date of filing: 18.02.2024
(51) Int. Cl.: H02M 1/00, H02S 40/34, H02K 7/20

(54) **PHOTOVOLTAIC OPTIMIZER AND PHOTOVOLTAIC POWER GENERATION SYSTEM**

(30) Priority: 31.07.2023 CN 202310960324
(71) Applicant: Huawei Digital Power Technologies Co., Ltd., Shenzhen, Guangdong 518043 (CN)
(72) Inventor: CHEN, Zhangrui, Shenzhen, Guangdong 518043 (CN); YIN, Wenle, Shenzhen, Guangdong 518043 (CN); WAN, Mingjia, Shenzhen, Guangdong 518043 (CN); YANG, Zekai, Shenzhen, Guangdong 518043 (CN)
(74) Representative: Isarpatent
(86) International application number: PCT/CN2024/077346
(87) International publication number: WO 2025/025567

(57) **Abstract**

This application provides a photovoltaic optimizer and a photovoltaic power generation system. The photovoltaic optimizer includes a housing, a printed circuit board module, and a cover portion. The cover portion is configured to cover the housing to form an accommodating cavity, and the accommodating cavity is configured to accommodate the printed circuit board module. The housing includes a mounting ear, a heat dissipation panel, and a connection panel, the printed circuit board module is disposed on a surface that is of the heat dissipation panel and that is close to the cover portion, the connection panel is configured to connect the mounting ear and the heat dissipation panel, and the mounting ear and the heat dissipation panel are respectively located at two ends that are disposed opposite to each other on the connection panel, so that the heat dissipation panel and the mounting ear are not located in a same plane. The mounting ear that mounts the photovoltaic optimizer and a heat dissipation portion of the photovoltaic optimizer are designed in an integrated manner, so that a structure and assembly of the photovoltaic optimizer are simplified, and costs are reduced. Further, costs of the photovoltaic power generation system are reduced.

## Description

This application claims priority to Chinese Patent Application No. 202310960324.9, filed with the China National Intellectual Property Administration on July 31, 2023 and entitled "PHOTOVOLTAIC OPTIMIZER AND PHOTOVOLTAIC POWER GENERATION SYSTEM", which is incorporated herein by reference in its entirety.

### TECHNICAL FIELD

Embodiments of this application relate to the field of photovoltaic technologies, and in particular, to a photovoltaic optimizer and a photovoltaic power generation system.

### BACKGROUND

In a photovoltaic power generation system, a photovoltaic optimizer can track maximum power of a photovoltaic module and quickly shut down the photovoltaic module. In an existing photovoltaic optimizer, a heat sink is separated from a mounting connection panel. After a plastic module is vertically inserted into the heat sink, a sheet metal connection panel is pushed into a heat sink sliding slot, to mount the photovoltaic optimizer. However, the photovoltaic optimizer has a complex structure, is not easy to assemble, and has high costs.

### SUMMARY

This application provides a photovoltaic optimizer and a photovoltaic power generation system. Both a mounting ear configured to mount the photovoltaic optimizer and a heat dissipation panel of the photovoltaic optimizer are disposed on a housing of the photovoltaic optimizer. In this way, the photovoltaic optimizer has a simple structure, is easy to assemble, and has low costs. Correspondingly, costs of the photovoltaic power generation system are also low.

According to a first aspect, a photovoltaic optimizer is provided, including a housing, a printed circuit board module, and a cover portion. The cover portion is configured to cover the housing to form an accommodating cavity, and the accommodating cavity is configured to accommodate the printed circuit board module. The housing includes a mounting ear, a heat dissipation panel, and a connection panel. The printed circuit board module is disposed on a surface that is of the heat dissipation panel and that is close to the cover portion. The connection panel is configured to connect the mounting ear and the heat dissipation panel. The mounting ear and the heat dissipation panel are respectively located at two ends that are disposed opposite to each other on the connection panel, so that the heat dissipation panel and the mounting ear are not located in a same plane.

According to the photovoltaic optimizer provided in this embodiment of this application, the mounting ear for mounting and the heat dissipation panel for heat dissipation are integrated as a whole, so that a quantity of components of the photovoltaic optimizer is reduced, a structure and an assembly process of the photovoltaic optimizer are simplified, product production efficiency is improved, and costs of the photovoltaic optimizer are reduced. When used as a whole, the mounting ear and the connection panel may also implement a heat dissipation function. This increases a heat dissipation area, and improves heat dissipation efficiency of the photovoltaic optimizer.

With reference to the first aspect, in some implementations of the first aspect, a distance between the surface that is of the heat dissipation panel and that is close to the cover portion and a surface that is of the mounting ear and that is away from the heat dissipation panel is greater than or equal to a distance between the surface that is of the heat dissipation panel and that is close to the cover portion and a surface that is of the cover portion and that is away from the heat dissipation panel.

In this application, that a distance between the surface that is of the heat dissipation panel and that is close to the cover portion and a surface that is of the mounting ear and that is away from the heat dissipation panel is greater than or equal to a distance between the surface that is of the heat dissipation panel and that is close to the cover portion and a surface that is of the cover portion and that is away from the heat dissipation panel can ensure that the surface that is of the cover portion and that is away from the heat dissipation panel does not protrude from the surface that is of the mounting ear and that is away from the heat dissipation panel. During mounting of the photovoltaic optimizer, it is avoided that the cover portion collides with a surface of a photovoltaic module. This ensures that the cover portion does not affect the mounting of the photovoltaic optimizer.

With reference to the first aspect, in some implementations of the first aspect, the distance between the surface that is of the heat dissipation panel and that is close to the cover portion and the surface that is of the cover portion and that is away from the heat dissipation panel includes a maximum distance between the surface that is of the heat dissipation panel and that is close to the cover portion and the surface that is of the cover portion and that is away from the heat dissipation panel.

In this application, the surface that is of the cover portion and that is away from the heat dissipation panel is not necessarily a plane. The distance may be a distance between a point that is on the surface that is of the cover portion and that is away from the heat dissipation panel and that has a largest distance from the heat dissipation panel and the surface that is of the heat dissipation panel and that is close to the cover portion.

With reference to the first aspect, in some implementations of the first aspect, a plane in which the mounting ear is located is perpendicular to a plane in which the connection panel is located.

That a plane in which the mounting ear is located is perpendicular to a plane in which the connection panel is located can minimize a length of the connection panel when a distance between the mounting ear and the heat dissipation panel is fixed, thereby reducing materials used for the connection panel and reducing costs.

With reference to the first aspect, in some implementations of the first aspect, a plane in which the heat dissipation panel is located is perpendicular to the plane in which the connection panel is located.

That a plane in which the heat dissipation panel is located is perpendicular to the plane in which the connection panel is located can minimize the length of the connection panel when the distance between the mounting ear and the heat dissipation panel is fixed, thereby reducing the materials used for the connection panel and reducing the costs. Particularly, when both the plane in which the heat dissipation panel is located and the plane in which the mounting ear is located are perpendicular to the plane in which the connection panel is located, materials used for the connection panel are most saved.

With reference to the first aspect, in some implementations of the first aspect, the connection panel includes a first connection end and a second connection end that are disposed opposite to each other. The first connection end is connected to the mounting ear in an arc-shaped bending manner, and the second connection end is connected to the heat dissipation panel at a right angle.

That the first connection end is connected to the mounting ear in an arc-shaped bending manner can avoid that a worker touches the first connection end and gets hurt during mounting, and improve security during mounting. That the second connection end is connected to the heat dissipation panel at a right angle can ensure that the cover portion can be in close contact with the heat dissipation panel when the cover portion covers the housing. This improves mounting stability.

With reference to the first aspect, in some implementations of the first aspect, that the cover portion is configured to cover the housing to form an accommodating cavity includes: The cover portion includes a side wall and a top. The side wall is disposed around the top, and the side wall extends in a direction that is of the top and that is close to the heat dissipation panel, so that the cover portion and the heat dissipation panel form the accommodating cavity.

In this application, the cover portion is in a shape of a cover. When the cover portion covers the housing to form the accommodating cavity, the heat dissipation panel is a surface of the accommodating cavity and is configured to place the printed circuit board module. The cover portion wraps the printed circuit board module, to isolate the printed circuit board module from an external environment, avoid an impact of static electricity and dust in the external environment on the printed circuit board module, and improve reliability of the photovoltaic optimizer.

With reference to the first aspect, in some implementations of the first aspect, no side wall is disposed around the surface that is of the heat dissipation panel and on which the printed circuit board module is disposed.

It should be understood that, in this application, that no side wall is disposed around the surface that is of the heat dissipation panel and on which the printed circuit board module is disposed means that no side wall is disposed on the surface of the heat dissipation panel, and the heat dissipation panel does not include the connection panel. In this application, the connection panel, the heat dissipation panel, and the mounting ear are uniformly located on a same housing, functionally partitioned on the same housing, and located at different locations of the housing. That the heat dissipation panel does not include the connection panel means that the connection panel is not a side wall of the heat dissipation panel. Therefore, that no side wall is disposed on the surface of the heat dissipation panel does not conflict with that the heat dissipation panel is connected to the connection panel.

With reference to the first aspect, in some implementations of the first aspect, the housing further includes at least one through hole, or the cover portion further includes at least one through hole, or the housing includes at least one first slot, the cover portion includes at least one second slot, and the at least one first slot and the at least one second slot form at least one through hole when the cover portion covers the housing. The photovoltaic optimizer further includes a cable, and the cable passes through the at least one through hole and is connected to the printed circuit board module.

In this application, the through hole used for the cable to pass through may be located in the housing, or may be located in the cover portion, or may be located in both the housing and the cover portion. When the through hole is located in the housing or the cover portion, processing is convenient. When the through hole is located in both the housing and the cover portion, the housing and the cover portion may be separated during mounting, and then the cable is connected to the printed circuit board module, so that mounting is convenient.

With reference to the first aspect, in some implementations of the first aspect, a fin-type heat dissipation structure is disposed on a surface that is of the heat dissipation panel and that is away from the printed circuit board module.

For example, the fin-type heat dissipation structure includes a heat dissipation fin.

The fin-type heat dissipation structure is used, so that a heat dissipation area of the photovoltaic optimizer can be increased, thereby improving heat dissipation efficiency of the photovoltaic optimizer.

With reference to the first aspect, in some implementations of the first aspect, the mounting ear includes at least one mounting hole, and the at least one mounting hole is used to connect to the target structure.

With reference to the first aspect, in some implementations of the first aspect, the cover portion includes an adhesive overflow slot. An opening of the adhesive overflow slot is located on a side that is of the cover portion and that is away from the printed circuit board module. At least one adhesive overflow hole is disposed at a bottom of the adhesive overflow slot. The at least one adhesive overflow hole is communicated with the accommodating cavity and the adhesive overflow slot. A depth of the adhesive overflow slot is greater than or equal to a vertical distance between a highest point of the accommodating cavity and the bottom of the adhesive overflow slot.

Specifically, if a potting adhesive appears in the adhesive overflow slot, it indicates that the potting adhesive fills a gap between an inner wall of the cover portion and the printed circuit board module; or if no potting adhesive appears in the adhesive overflow slot, it indicates that the potting adhesive does not fill a gap between an inner wall of the cover portion and the printed circuit board module.

In this application, the adhesive overflow slot disposed on the cover portion may replace an adhesive overflow cup, so that the adhesive overflow cup is not manufactured in a potting process, and costs are reduced.

With reference to the first aspect, in some implementations of the first aspect, the cover portion further includes a potting hole, and the potting hole is used to fill the accommodating cavity with a potting adhesive.

The potting adhesive is used to fill the gap between the inner wall of the cover portion and the printed circuit board module. The potting adhesive may seal the printed circuit board module in the accommodating cavity, so that the printed circuit board module is isolated, thereby achieving an objective of insulating the printed circuit board module. In addition, the potting adhesive may further transfer heat generated by a device on a printed circuit board to the housing, and further transfer the heat to surrounding air outside the housing, to enhance a heat dissipation capability of the photovoltaic optimizer. The potting adhesive may further achieve an objective of waterproof sealing for the printed circuit board module accommodated in the accommodating cavity.

With reference to the first aspect, in some implementations of the first aspect, an insulation layer is disposed between the heat dissipation panel and the printed circuit board.

That an insulation layer is disposed between the heat dissipation panel and a printed circuit board can increase a creepage distance, improve safety and the reliability of the photovoltaic optimizer, and enable the photovoltaic optimizer to better meet a safety regulation. For example, the insulation layer may be an insulation tape.

With reference to the first aspect, in some implementations of the first aspect, a heat conduction layer is disposed between the heat dissipation panel and the printed circuit board.

The heat conduction layer may fill a gap between the heat dissipation panel and the printed circuit board, to improve heat dissipation efficiency. The heat conduction layer uses a material with high heat conductivity, such as silica gel.

According to a second aspect, a photovoltaic power generation system is provided. The photovoltaic power generation system includes the photovoltaic optimizer and the photovoltaic module according to any one of the first aspect and the possible implementations of the first aspect. The photovoltaic optimizer is mounted on the photovoltaic module by using the mounting ear of the photovoltaic optimizer, the heat dissipation panel of the photovoltaic optimizer faces away from the photovoltaic module, and an output end of the cable of the photovoltaic optimizer is connected to the photovoltaic module.

With reference to the second aspect, in some implementations of the second aspect, the distance between the surface that is of the heat dissipation panel and that is close to the cover portion and the surface that is of the mounting ear and that is away from the heat dissipation panel is a first distance. A distance between the surface that is of the mounting ear and that is away from the heat dissipation panel and a surface that is of the photovoltaic module and that is close to the photovoltaic optimizer is a second distance. The distance between the surface that is of the heat dissipation panel and that is close to the cover portion and the surface that is of the cover portion and that is away from the heat dissipation panel is a third distance. A sum of the first distance and the second distance is greater than or equal to the third distance.

For technical effects of the second aspect, refer to corresponding descriptions in the first aspect. Details are not described herein again.

### BRIEF DESCRIPTION OF DRAWINGS

FIG. 1 is a diagram of a photovoltaic power generation system according to an embodiment of this application;
FIG. 2 is an exploded diagram of a photovoltaic optimizer according to an embodiment of this application; and
FIG. 3 is a diagram of a photovoltaic optimizer according to an embodiment of this application.

### DESCRIPTION OF EMBODIMENTS

The following describes technical solutions of embodiments in this application with reference to accompanying drawings.

In the descriptions of embodiments of this application, unless otherwise stated, "/" means "or", for example, A/B may represent A or B. The term "and/or" in this specification describes only an association relationship between associated objects, and indicates that three relationships may exist. For example, A and/or B may represent three cases: Only A exists, both A and B exist, and only B exists.

In embodiments of this application, prefix words such as "first", "second", "third", "fourth", and "fifth" are used only to distinguish between different described objects, and do not limit a location, a sequence, a priority, a quantity, content, or the like of the described objects. In embodiments of this application, use of a prefix word, such as an ordinal number, used to distinguish between described objects does not constitute a limitation on the described objects. For a description of the described objects, refer to the description of the context in the claims or embodiments. The use of such a prefix word should not constitute an unnecessary limitation. In addition, in the description of this embodiment, unless otherwise stated, "a plurality of" means two or more than two.

Reference to "an embodiment", "some embodiments", or the like described in this specification indicates that one or more embodiments of this application include a specific feature, structure, or characteristic described with reference to the embodiment. Therefore, statements such as "in some embodiments" that appear at different places in this specification do not necessarily mean reference to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

"Equal to" in this application is not strictly equal to, but falls within an allowed error range. "Flush" is not strictly tangent, but falls within an allowed error range.

In embodiments of this application, a same reference numeral indicates a same constituent part or a same component. In embodiments of this application, for a plurality of same components, only one of the components may be used as an example in the accompanying drawings to mark reference numerals. For other same parts or components, reference numerals are also applicable. In addition, dimensions and sizes of the components shown in the accompanying drawings are merely examples.

In a photovoltaic power generation system, a photovoltaic optimizer can track maximum power of a photovoltaic module and quickly shut down the photovoltaic module. A printed circuit board of an existing photovoltaic optimizer is disposed in an accommodating cavity of a plastic housing. In addition, a heat equalizing sheet and a heat sink need to be disposed in the plastic housing, to implement heat dissipation during operating of the photovoltaic optimizer. However, the photovoltaic optimizer has a complex structure, and is not easy to assemble.

In view of this, embodiments of this application provide a photovoltaic optimizer and a photovoltaic power generation system. A printed circuit board of the photovoltaic optimizer is disposed in an accommodating cavity formed by a metal housing, of a hollow structure, having an opening and an end cover, and a cable is connected to the printed circuit board through a through hole on the end cover. In this way, in an operating process of the photovoltaic optimizer, heat generated by a device mounted on the printed circuit board is dissipated outside the metal housing by using the metal housing. Further, the photovoltaic optimizer not only can ensure good heat dissipation effect, but also has a simple structure and is easy to assemble. Correspondingly, costs of the photovoltaic power generation system are also low.

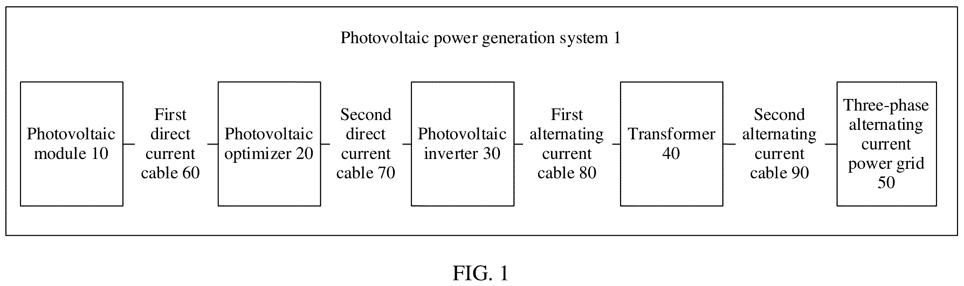

The following first describes in detail the photovoltaic power generation system provided in embodiments of this application with reference to FIG. 1.

FIG. 1 is a diagram of the photovoltaic power generation system according to an embodiment of this application.

As shown in FIG. 1, the photovoltaic power generation system 1 provided in this embodiment of this application includes one or more photovoltaic modules 10, one or more photovoltaic optimizers 20, a photovoltaic inverter 30, a transformer 40, a three-phase alternating current power grid 50, a first direct current cable 60, a second direct current cable 70, a first alternating current cable 80, and a second alternating current cable 90. The one or more photovoltaic modules 10 are connected to the photovoltaic optimizers 20 through the first direct current cable 60, and a connection relationship between the photovoltaic module 10 and the photovoltaic optimizer 20 may be a one-to-one connection. The one or more photovoltaic optimizers 20 are connected to the photovoltaic inverter 30 through the second direct current cable 70. The photovoltaic inverter 30 converts a direct current into an alternating current, and an alternating current side of the photovoltaic inverter 30 is connected to the transformer 40 through the first alternating current cable 80. The transformer 40 is connected to the three-phase alternating current power grid 50 through the second alternating current cable 90. In this way, the alternating current output by the photovoltaic inverter 30 flows into the three-phase alternating current power grid 50 after passing through the transformer 40. The following describes in detail each device included in the photovoltaic power generation system 1.

The photovoltaic power generation system is a power generation system that uses photovoltaic effect of semiconductor materials to convert solar radiation energy into electric energy. The photovoltaic power generation system provided in this embodiment of this application can energize an electric vehicle. The electric vehicle includes a pure electric vehicle/battery electric vehicle (pure electric vehicle/battery electric vehicle, pure EV/battery EV), a hybrid electric vehicle (hybrid electric vehicle, HEV), a range extended electric vehicle (range extended electric vehicle, REEV), a plug-in hybrid electric vehicle (plug-in hybrid electric vehicle, PHEV), a new energy vehicle (new energy vehicle, NEV), or the like.

The photovoltaic module 10 may also be referred to as a photovoltaic array, and includes a plurality of photovoltaic (Photovoltaic, PV) strings (strings). Each photovoltaic string includes a plurality of photovoltaic panels connected in series. The photovoltaic panel is configured to convert light energy into electric energy. The electric energy generated by the photovoltaic panel is a direct current (direct current, DC). Voltages at both ends of the photovoltaic string are equal to a sum of voltages generated by the plurality of photovoltaic panels. Output power of the photovoltaic module may represent electric energy output by the photovoltaic module in a unit time.

The photovoltaic optimizer 20 may also be referred to as a photovoltaic power optimizer. The photovoltaic optimizer 20 may improve a power generation capacity of the photovoltaic power generation system 1 by continuously tracking a maximum power point of each photovoltaic module 10, has functions such as component-level shutdown and component-level monitoring, and supports a long string design to capture the maximum power point. The photovoltaic optimizer 20 may be mounted on the photovoltaic module 10. For example, the photovoltaic optimizer 20 may be mounted on a section bar frame of the photovoltaic module 10 by using a connection panel.

The photovoltaic inverter 30 is configured to convert an input direct current into an alternating current (alternating current, AC), in other words, perform DC-AC conversion. The photovoltaic inverter 30 may also be referred to as a DC-AC converter.

The transformer 40 may be configured to perform voltage conversion on the alternating current, to adjust a voltage value of an input alternating current voltage. It should be understood that both an input and an input of the transformer 40 are alternating currents. The transformer 40 may boost alternating currents output by one or more photovoltaic inverters 30.

In the photovoltaic power generation system 1, an area of each photovoltaic module 10 is usually fixed. When light intensity of light remains unchanged, a larger included angle between light irradiated on the photovoltaic module 10 and a plane in which the photovoltaic module 10 is located, namely, a smaller incident angle at which the photovoltaic module 10 is irradiated by the light, indicates more electric energy output by the photovoltaic module 10. When the photovoltaic module 10 is vertically irradiated by the light, in other words, the included angle between the light and the plane in which the photovoltaic module 10 is located is 90°, which reaches a maximum value, the output power of the photovoltaic module 10 reaches a maximum value.

When the photovoltaic power generation system 1 includes the plurality of photovoltaic optimizers 20, the photovoltaic power generation system 1 further includes a combiner box. The combiner box is configured to combine direct currents generated by the plurality of photovoltaic modules 10, and input a combined output to the photovoltaic inverter 30 after the output passes through a circuit breaker and lightning protection processing is performed on the output.

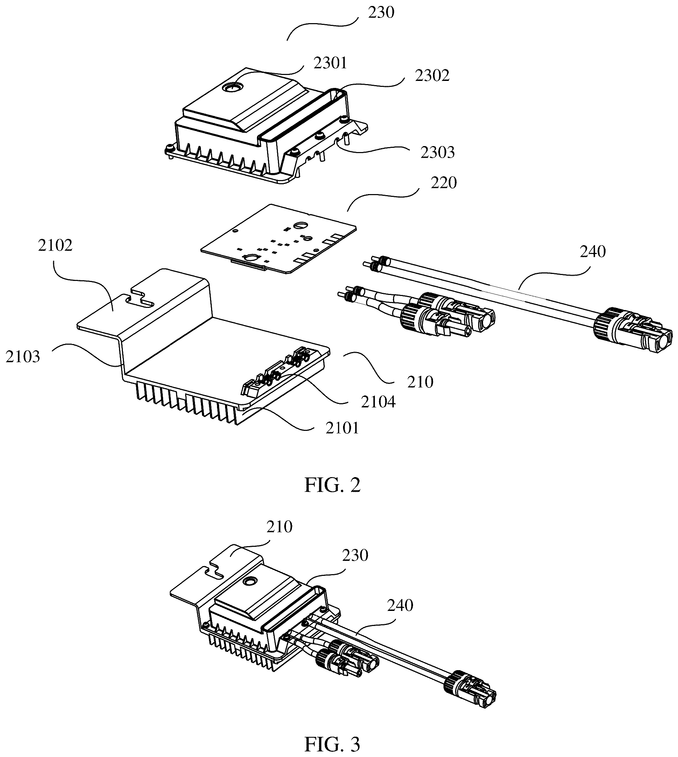

The following describes in detail a photovoltaic optimizer 20 provided in an embodiment of this application with reference to FIG. 2.

FIG. 2 is an exploded diagram of the photovoltaic optimizer according to an embodiment of this application. As shown in FIG. 2, the photovoltaic optimizer includes a housing 210, a printed circuit board module 220, and a cover portion 230. The cover portion 230 is configured to cover the housing 210 to form an accommodating cavity, and the accommodating cavity is configured to accommodate the printed circuit board module 220. The printed circuit board module 220 includes a printed circuit board and at least one device mounted on the printed circuit board. A power tracking circuit is disposed on the printed circuit board.

The housing 210 includes a heat dissipation panel 2101, a mounting ear 2102, and a connection panel 2103. The connection panel is configured to connect the mounting ear and the heat dissipation panel. The heat dissipation panel 2101, the mounting ear 2102, and the connection panel 2103 present a Z-shaped structure. The mounting ear 2102 and the heat dissipation panel 2101 are respectively located at two ends that are disposed opposite to each other on the connection panel 2103, so that the heat dissipation panel 2101 and the mounting ear 2102 are not located in a same plane.

In a possible manner, the heat dissipation panel 2101, the mounting ear 2102, and the connection panel 2103 are produced and manufactured as a whole. In a possible manner, at least one of the heat dissipation panel 2101, the mounting ear 2102, and the connection panel 2103 is used as an independent individual, and is fastened to another component through welding. Welding is merely an example of a fastening manner, and may alternatively be bonding, riveting, or screw connection. This is not limited in this application.

In FIG. 2, both the heat dissipation panel 2101 and the mounting ear 2102 are of a sheet structure, the heat dissipation panel 2101 is parallel to the mounting ear 2102, and the connection panel 2103 is separately perpendicular to the heat dissipation panel 2101 and the mounting ear 2102. A structure of the housing 210 in FIG. 2 is merely an example. The heat dissipation panel 2101 and the mounting ear 2102 may not be completely parallel, and there may be a specific angular deviation between the heat dissipation panel 2101 and the mounting ear 2102. Correspondingly, the connection panel 2103 may not be completely perpendicular to the heat dissipation panel 2101 and the mounting ear 2102, and there may also be a specific angular deviation.

It should be understood that, in consideration of a current actual mounting requirement, a distance between a surface that is of the heat dissipation panel 2101 and that is close to the cover portion 230 and a surface that is of the mounting ear 2102 and that is away from the heat dissipation panel 2101 is greater than or equal to a distance between the surface that is of the heat dissipation panel 2101 and that is close to the cover portion 230 and a surface that is of the cover portion 230 and that is away from the heat dissipation panel 2101, to meet a mounting requirement that the cover portion does not protrude from a plane in which the surface that is of the mounting ear 2102 and that is away from the heat dissipation panel 2101 is located.

In this application, the surface that is of the cover portion and that is away from the heat dissipation panel is not necessarily a plane. The distance between the surface that is of the heat dissipation panel and that is close to the cover portion and the surface that is of the cover portion and that is away from the heat dissipation panel may be a distance between a point that is on the surface that is of the cover portion and that is away from the heat dissipation panel and that has a largest distance from the heat dissipation panel and the surface that is of the heat dissipation panel and that is close to the cover portion.

It should be noted that, if the actual mounting requirement changes, the limitation is also adjusted accordingly. For example, if the cover portion of the photovoltaic optimizer can protrude from the plane in which the surface that is of the mounting ear 2102 and that is away from the heat dissipation panel 2101 is located, a relative relationship between the distance between the surface that is of the heat dissipation panel 2101 and that is close to the cover portion 230 and the surface that is of the mounting ear 2102 and that is away from the heat dissipation panel 2101 and the distance between the surface that is of the heat dissipation panel 2101 and that is close to the cover portion 230 and the surface that is of the cover portion 230 and that is away from the heat dissipation panel 2101 is not limited.

In this application, the printed circuit board module is disposed on the surface that is of the heat dissipation panel and that is close to the cover portion, and heat dissipation and heat equalization are performed on at least one device on the printed circuit board module 220. It should be understood that the surface that is of the heat dissipation panel and that is close to the cover portion may be in direct contact with the printed circuit board module, or may not be in direct contact with the printed circuit board module. For example, there is a mounting bracket on the surface that is of the heat dissipation panel and that is close to the cover portion, and the printed circuit board module is placed on the mounting bracket.

In FIG. 2, the printed circuit board and the heat dissipation panel 2101 may be fastened through a bolt. Using the bolt for fastening can improve stability of the photovoltaic optimizer and improve security.

It should be understood that bolt fastening is merely an example of a fastening manner between the printed circuit board and the heat dissipation panel 2101. For example, the printed circuit board and the heat dissipation panel 2101 may also be fastened through adhesive bonding. Compared with bolt fastening, there is no need to consider avoiding a product compliance distance from a line on the printed circuit board, and there is no need to consider avoiding a pressure sensitive device. This facilitates reduction of a dimension of the printed circuit board.

In FIG. 2, a fin-type heat dissipation structure, for example, a heat dissipation fin, is disposed on a surface that is of the heat dissipation panel 2101 and that is away from the printed circuit board module 220. As shown in FIG. 2, a surface that is of the heat dissipation panel 2101 and that is used to fasten the printed circuit board is a plane, and the other surface is in a sawtooth shape. There are sheet structures perpendicular to the plane used to fasten the printed circuit board. Using the fin-type heat dissipation structure can increase a heat dissipation area and improve heat dissipation efficiency. It should be understood that the fin-type heat dissipation structure is merely an example of the heat dissipation panel 2101. The heat dissipation panel 2101 in this application may be another structure that can implement a heat dissipation function. For example, there may be no fin on the heat dissipation panel 2101, and heat is dissipated by using a housing plane. This is not limited.

A material of the heat dissipation panel 2101 may be metal. The heat dissipation panel 2101 may be formed by molding or welding a sheet metal, or formed by molding or cutting a profile.

In a possible manner, a material of the heat dissipation panel 2101 is aluminum.

It should be understood that aluminum is lighter in metals of a same unit volume. In addition, aluminum is cheap and can reduce weight of the photovoltaic optimizer while reducing costs.

It should be noted that aluminum is merely used as an example of the material of the heat dissipation panel 2101. For example, the material of the heat dissipation panel 2101 may alternatively be aluminum alloy. Other metals should also fall within the protection scope of this application, for example, copper having high heat conductivity and high strength.

It should be further understood that the material of the heat dissipation panel 2101 may alternatively be a nonmetal having high heat conductivity. For example, the material of the heat dissipation panel 2101 may include graphite, and may further include a polycarbonate material, PC plastic. If a nonmetallic material is used, the heat dissipation panel 2101 may be processed in an injection molding manner.

In a possible implementation, a heat conduction layer may be added between the heat dissipation panel 2101 and the printed circuit board module 220, and the heat conduction layer may fill a heat conduction gap between a heat emitting device and a heat dissipation bottom surface, to improve the heat dissipation efficiency. For example, the heat conduction layer may be a heat conduction gel or a heat conduction pad. Further, a material of the heat conduction layer may be silicone grease. This is not limited in this application.

In a possible implementation, an insulation layer may be added between the heat dissipation panel 2101 and the printed circuit board module 220. The insulation layer may increase a creepage distance, thereby improving security of the photovoltaic optimizer. For example, the insulation layer may be an insulation tape.

The mounting ear 2102 is configured to mount the photovoltaic optimizer on the photovoltaic module. The mounting ear 2102 includes at least one mounting hole. During mounting, the photovoltaic optimizer is fastened to a section bar frame of the photovoltaic module by using a buckle or a screw through the at least one mounting hole. For example, the photovoltaic module may include a photovoltaic power generation panel.

A shape of the mounting hole in FIG. 2 is merely an example, and the shape of the mounting hole may be adjusted based on an actual mounting requirement. This is not limited in this application.

For a material of the mounting ear 2102, refer to the material of the heat dissipation panel 2101. Details are not described herein again.

The connection panel 2103 is configured to connect the heat dissipation panel 2101 and the mounting ear 2102 as a whole. For a material of the connection panel 2103, refer to the material of the heat dissipation panel 2101. Details are not described herein again.

In a possible implementation, the connection panel 2103 includes a first connection end and a second connection end that are disposed opposite to each other. The first connection end is connected to the mounting ear 2102 in an arc-shaped bending manner, and the second connection end is connected to the heat dissipation panel 2101 at a right angle. The mounting ear 2102 is connected in the arc-shaped bending manner, so that a case in which a worker is scratched by a joint between the connection panel 2103 and the mounting ear 2102 during mounting can be avoided. The heat dissipation panel 2101 is connected at the right angle, so that it can be ensured that the heat dissipation panel 2101 is in close contact with the cover portion 230 when the cover portion 230 covers the housing 210.

It should be understood that the heat dissipation panel 2101, the mounting ear 2102, and the connection panel 2103 may be processed as a whole, to reduce a quantity of components of the photovoltaic optimizer, and improve product production efficiency. When the heat dissipation panel 2101, the mounting ear 2102 and the connection panel 2103 are used as a whole, the mounting ear 2102 and the connection panel 2103 may also perform the heat dissipation function, increase a heat dissipation area, and improve the heat dissipation efficiency. Heat may be conducted to the mounting ear 2102 by using the heat dissipation panel 2101, and then conducted to the section bar frame of the photovoltaic module.

In this application, when the heat dissipation panel 2101, the mounting ear 2102, and the connection panel 2103 are used as a whole and are made of a metal material, the heat dissipation panel 2101, the mounting ear 2102, and the connection panel 2103 can be equipotential, thereby resolving a housing grounding problem.

The printed circuit board module 220 is accommodated in the accommodating cavity formed by the housing 210 and the cover portion 230. The printed circuit board module 220 includes the printed circuit board and the at least one device mounted on the printed circuit board.

For example, the device mounted on the printed circuit board includes a programmable logic controller (programmable logic controller, PLC), a metal-oxide-semiconductor field-effect transistor (metal-oxide-semiconductor field-effect transistor, MOSFET) device, and the like.

Further, the at least one device mounted on the printed circuit board may be a surface-mount power device that is easy to assemble and has a lower parasitic parameter, and the at least one device may implement housing-attached heat dissipation by directly using a heat dissipation material. For example, the at least one device mounted on the printed circuit board may be a gallium nitride (GaN) power tube or a silicon carbide (SiC) power tube. A third-generation semiconductor represented by GaN and SiC has a high breakdown electric field strength, a higher switching frequency and an on-resistance, a faster switching speed, and a lower loss. This facilitates evolution to miniaturization.

In embodiments of this application, the printed circuit board module 220 may also be referred to as a printed circuit board assembly (printed circuit board assembly, PCBA).

In some embodiments, in addition to the printed circuit board and the at least one device mounted on the printed circuit board, the printed circuit board module 220 further has a bearing rack. The bearing rack is configured to bear the printed circuit board module 220, so that the printed circuit board module 220 is not in direct contact with the housing 210.

The cover portion 230 is configured to cover the housing 210 to form the accommodating cavity. The cover portion 230 includes a side wall and a top. The side wall is disposed around the top, and the side wall extends in a direction that is of the top and that is close to the heat dissipation panel 2101, so that the cover portion and the heat dissipation panel form the accommodating cavity.

To facilitate the cover portion 230 to cover the housing 210, no side wall is disposed around the surface that is of the heat dissipation panel 2101 and that is close to the printed circuit board module 220. It should be noted that, in this application, the heat dissipation panel 2101, the mounting ear 2102, and the connection panel 2103 all belong to a part of the housing 210 in terms of structure. However, the connection panel 2103 is not a component of the heat dissipation panel 2101. Therefore, whether a side wall is disposed around the surface that is of the heat dissipation panel 2101 and that is close to the printed circuit board module 220 does not consider the connection panel 2103. That is, that no side wall is disposed around the surface that is of the heat dissipation panel 2101 and that is close to the printed circuit board module 220 does not conflict with the connection panel 2103.

The cover portion 230 includes a potting hole 2301. The potting hole 2301 is used to inject a potting adhesive into the accommodating cavity. For example, the potting adhesive injected into the accommodating cavity may be silicon.

The cover portion 230 in FIG. 2 further includes an adhesive overflow slot 2302. An opening of the adhesive overflow slot 2302 is located on a side that is of the cover portion 230 and that is away from the printed circuit board module 220. At least one adhesive overflow hole is disposed at a bottom of the adhesive overflow slot 2302. The at least one adhesive overflow hole is communicated with the accommodating cavity and the adhesive overflow slot 2302. A depth of the adhesive overflow slot 2302 is greater than or equal to a vertical distance between a highest point of the accommodating cavity and the bottom of the adhesive overflow slot 2302.

The adhesive overflow slot 2302 is configured to determine whether the potting adhesive completely fills the entire accommodating cavity. Specifically, the adhesive overflow slot 2302 is a structure protruding from the accommodating cavity. If it is observed that the potting adhesive appears in the adhesive overflow slot 2302, it indicates that the potting adhesive has completely filled the entire accommodating cavity.

The adhesive overflow slot is disposed on the cover portion 230, so that an adhesive overflow cup in a process of injecting the potting adhesive can be saved, thereby reducing costs.

In FIG. 2, that the adhesive overflow slot is disposed on the cover portion 230 is merely an example. The adhesive overflow slot may alternatively not be disposed on the cover portion 230. For example, a through hole is opened on the cover portion 230, and in the process of injecting the potting adhesive, the adhesive overflow cup is used on the through hole. If the potting adhesive appears in the adhesive overflow cup, it indicates that the potting adhesive has completely filled the entire accommodating cavity.

The cover portion 230 may be made of a material with good formability and wear resistance, for example, plastic.

The photovoltaic optimizer further includes a cable 240, and an input end of the cable 240 is connected to the printed circuit board through at least one through hole. In FIG. 2, the heat dissipation panel 2101 includes a bearing table. At least one first slot 2104 is disposed on a surface that is of the bearing table and that is in contact with the cable 240. At least one second slot 2103 is disposed on a surface that is of the cover portion 230 and that is in contact with the cable 240. When the cover portion 230 covers the housing 210, the at least one first slot 2104 and the at least one second slot 2103 form the at least one through hole, so that the input end of the cable 240 passes through the at least one through hole and is connected to the printed circuit board.

It should be understood that a location of the through hole through which the cable 240 passes in FIG. 2 is merely an example, and the through hole through which the cable 240 passes may be located only on the housing 210 or located only on the cover portion 230. This is not limited in this application.

The cable 240 passes through at least one through hole on the whole formed by the cover portion 230 covering the housing 210 and is connected to the printed circuit board. A manner of connecting the cable 240 to the printed circuit board is not limited.

In a possible implementation, the cable 240 is electrically connected to the printed circuit board in the welding manner.

In a possible implementation, a socket is disposed on the printed circuit board, and the cable 240 may be directly inserted into the socket to be electrically connected to the printed circuit board.

The photovoltaic optimizer in this application uses a sandwich architecture of a housing, a cover portion, and a printed circuit board module. This simplifies an architecture of the photovoltaic optimizer, reduces a quantity of production line procedures and production devices, and reduces costs.

In an embodiment, an assembly sequence of the photovoltaic optimizer is: fastening the printed circuit board module 220 to the housing 210, then connecting the cable 240 to the printed circuit board module 220, and finally fastening the cover portion 230 to the housing 210.

An assembled photovoltaic optimizer is shown in FIG. 3. FIG. 3 is a diagram of the photovoltaic optimizer according to an embodiment of this application. Because a printed circuit board module is mounted an accommodating cavity formed by a housing and a cover portion, the printed circuit module is not shown in FIG. 3.

In FIG. 3, the cover portion is fastened to the housing by using a connection structure.

In an embodiment, the connection structure includes an adhesive. The cover portion may be fastened to the housing in an adhesive bonding manner.

For example, the adhesive is a gel formed by using a gel process. For another example, the adhesive is a curing adhesive formed by using a curing process.

In an embodiment, the connection structure includes a screw. The cover portion may be fastened to the housing in a screw connection manner. The screw is a self-locking screw.

In this application, when the photovoltaic optimizer is mounted on a photovoltaic module, a distance between a surface that is of a heat dissipation panel of the photovoltaic optimizer and that is close to a cover portion of the photovoltaic optimizer and a surface that is of a mounting ear of the photovoltaic optimizer and that is away from the heat dissipation panel of the photovoltaic optimizer is a first distance, a distance between a surface that is of the mounting ear of the photovoltaic optimizer and that is away from the heat dissipation panel of the photovoltaic optimizer and a surface that is of the photovoltaic module of the photovoltaic optimizer and that is close to the photovoltaic optimizer is a second distance, and a distance between the surface that is of the heat dissipation panel of the photovoltaic optimizer and that is close to the cover portion of the photovoltaic optimizer and a surface that is of the cover portion of the photovoltaic optimizer and that is away from the heat dissipation panel of the photovoltaic optimizer is a third distance. A sum of the first distance and the second distance is greater than or equal to the third distance, to ensure that a specific distance is kept between the photovoltaic optimizer and the photovoltaic module, so that mounting of the photovoltaic optimizer does not conflict with the photovoltaic module.

The photovoltaic optimizer in this application is easy to assemble, detection and maintenance are convenient, and production efficiency can be improved.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A photovoltaic optimizer, comprising a housing, a printed circuit board module, and a cover portion, wherein
the cover portion is configured to cover the housing to form an accommodating cavity, and the accommodating cavity is configured to accommodate the printed circuit board module; and
the housing comprises a mounting ear, a heat dissipation panel, and a connection panel, the printed circuit board module is disposed on a surface that is of the heat dissipation panel and that is close to the cover portion, the connection panel is configured to connect the mounting ear and the heat dissipation panel, and the mounting ear and the heat dissipation panel are respectively located at two ends that are disposed opposite to each other on the connection panel, so that the heat dissipation panel and the mounting ear are not located in a same plane.

2. The photovoltaic optimizer according to claim 1, wherein a distance between the surface that is of the heat dissipation panel and that is close to the cover portion and a surface that is of the mounting ear and that is away from the heat dissipation panel is greater than or equal to a distance between the surface that is of the heat dissipation panel and that is close to the cover portion and a surface that is of the cover portion and that is away from the heat dissipation panel.

3. The photovoltaic optimizer according to claim 2, wherein the distance between the surface that is of the heat dissipation panel and that is close to the cover portion and the surface that is of the cover portion and that is away from the heat dissipation panel comprises:
a maximum distance between the surface that is of the heat dissipation panel and that is close to the cover portion and the surface that is of the cover portion and that is away from the heat dissipation panel.

4. The photovoltaic optimizer according to any one of claims 1 to 3, wherein a plane in which the mounting ear is located is perpendicular to a plane in which the connection panel is located.

5. The photovoltaic optimizer according to any one of claims 1 to 4, wherein a plane in which the heat dissipation panel is located is perpendicular to the plane in which the connection panel is located.

6. The photovoltaic optimizer according to any one of claims 1 to 5, wherein the connection panel comprises a first connection end and a second connection end that are disposed opposite to each other, the first connection end is connected to the mounting ear in an arc-shaped bending manner, and the second connection end is connected to the heat dissipation panel at a right angle.

7. The photovoltaic optimizer according to any one of claims 1 to 6, wherein that the cover portion is configured to cover the housing to form an accommodating cavity comprises:
the cover portion comprises a side wall and a top, wherein the side wall is disposed around the top, and the side wall extends in a direction that is of the top and that is close to the heat dissipation panel, so that the cover portion and the heat dissipation panel form the accommodating cavity.

8. The photovoltaic optimizer according to any one of claims 1 to 7, wherein no side wall is disposed around the surface that is of the heat dissipation panel and on which the printed circuit board module is disposed.

9. The photovoltaic optimizer according to any one of claims 1 to 8, wherein
the housing further comprises at least one through hole, or the cover portion further comprises at least one through hole, or the housing comprises at least one first slot, the cover portion comprises at least one second slot, and the at least one first slot and the at least one second slot form at least one through hole when the cover portion covers the housing; and
the photovoltaic optimizer further comprises a cable, and the cable passes through the at least one through hole and is connected to the printed circuit board module.

10. The photovoltaic optimizer according to any one of claims 1 to 9, wherein a fin-type heat dissipation structure is disposed on a surface that is of the heat dissipation panel and that is away from the printed circuit board module.

11. The photovoltaic optimizer according to any one of claims 1 to 10, wherein the mounting ear comprises at least one mounting hole, and the at least one mounting hole is used to connect to the target structure.

12. The photovoltaic optimizer according to any one of claims 1 to 11, wherein the cover portion comprises an adhesive overflow slot, an opening of the adhesive overflow slot is located on a side that is of the cover portion and that is away from the printed circuit board module, at least one adhesive overflow hole is disposed at a bottom of the adhesive overflow slot, the at least one adhesive overflow hole is communicated with the accommodating cavity and the adhesive overflow slot, and a depth of the adhesive overflow slot is greater than or equal to a vertical distance between a highest point of the accommodating cavity and the bottom of the adhesive overflow slot.

13. The photovoltaic optimizer according to any one of claims 1 to 12, wherein the cover portion further comprises a potting hole, and the potting hole is used to fill the accommodating cavity with a potting adhesive.

14. A photovoltaic power generation system, comprising the photovoltaic optimizer according to any one of claims 1 to 13 and a photovoltaic module, wherein the photovoltaic optimizer is mounted on the photovoltaic module by using the mounting ear of the photovoltaic optimizer, the heat dissipation panel of the photovoltaic optimizer faces away from the photovoltaic module, and an output end of the cable of the photovoltaic optimizer is connected to the photovoltaic module.

15. The photovoltaic power generation system according to claim 14, wherein the distance between the surface that is of the heat dissipation panel and that is close to the cover portion of the photovoltaic optimizer and the surface that is of the mounting ear and that is away from the heat dissipation panel is a first distance, a distance between the surface that is of the mounting ear and that is away from the heat dissipation panel and a surface that is of the photovoltaic module and that is close to the photovoltaic optimizer is a second distance, the distance between the surface that is of the heat dissipation panel and that is close to the cover portion of the photovoltaic optimizer and the surface that is of the cover portion of the photovoltaic optimizer and that is away from the heat dissipation panel is a third distance, and a sum of the first distance and the second distance is greater than or equal to the third distance.
